# EUROPEAN PATENT APPLICATION

(11) **EP 3 882 986 A1**
(43) Date of publication of application: **22.09.2021**
(21) Application number: 20192372.9
(22) Date of filing: 24.08.2020
(51) Int. Cl.: H01L 31/107, H01L 27/144

(54) **PHOTODETECTOR, OPTICAL DETECTION SYSTEM, LIDAR DEVICE, AND MOVABLE BODY**

(30) Priority: 17.03.2020 JP 2020046181
(71) Applicant: KABUSHIKI KAISHA TOSHIBA, Minato-ku Tokyo 105-0023 (JP)
(72) Inventor: Atsuta, Masaki, Tokyo, 105-0023 (JP); Suzuki, Kazuhiro, Tokyo, 105-0023 (JP); Fujiwara, Ikuo, Tokyo, 105-0023 (JP); Kwon, Honam, Tokyo, 105-0023 (JP); Nobusa, Yuki, Tokyo, 105-0023 (JP)
(74) Representative: Hoffmann Eitle

(57) **Abstract**

A photodetector (10A, 10A', 10B, 10C, 10D, 10E, 10F, 10F') includes a first semiconductor layer (12, 19) including a light detection region (E1) and a peripheral region (E2) on a first surface on which light is incident. The light detection region (E1) is a region in which light detecting units (30) are arrayed. The peripheral region (E2) is a semiconductor region disposed on the periphery of the light detection region (E1) and not including a light detecting unit (30). The density of a lattice defect in a first layer region (40) that is at least a part in a thickness direction of the peripheral region (E2) is higher than the density of a lattice defect in a second layer region (15, 17) adjacent to the first layer region (40) in a direction intersecting the thickness direction in the light detection region (E1).

## Description

### FIELD

Arrangements described herein relate generally to a photodetector, an optical detection system, a laser imaging detection and ranging (LIDAR) device, and a movable body.

### BACKGROUND

Photodetectors such as silicon photomultipliers (SiPMs) that are arrays of a plurality of avalanche photodiodes (APD) are known. SiPMs operate in a region called Geiger mode when APDs are operated at a reverse-bias voltage higher than the breakdown voltage of APDs. The gain of APDs in Geiger mode operation is as high as 10⁵ to 10⁶, enabling measurement of weak light of even a single photon.

In APDs that constitute SiPMs, when photons are incident, avalanche breakdown (ABD) occurs, causing secondary photons in silicon (Si) crystals. The secondary photons propagate through the surroundings to create electron-hole pairs (EHP) by excitation. Conventional technologies are described in Japanese Patent Application Laid-open No. 2001-352095 and Fabio Acerbi et al., "Silicon Photomultipliers: Technology Optimizations for Ultraviolet, Visible and Near-Infrared Range", Instruments 2019,3,15;doi:10.3390/instruments3010015 www.mdpi.com/journal/instruments, for example.

Conventionally, electrons or holes of the created electron-hole pairs may diffuse and reach the initial APD with a delay for the time taken for diffusion, and trigger ABD again, causing delayed noise called afterpulsing. Moreover, electrons or holes of the created electron-hole pairs may diffuse and reach an APD different from the initial one with a delay for the time taken for diffusion, and trigger ABD, causing noise called delayed crosstalk. In this way, conventionally, noise sometime occurs.

### BRIEF DESCRIPTION OF THE DRAWINGS

FIG. 1 is a diagram illustrating a photodetector according to a first arrangement;
FIG. 2 is a schematic diagram of the photodetector according to the first arrangement;
FIG. 3 is a schematic diagram of the photodetector according to the first arrangement;
FIG. 4 is a schematic diagram illustrating a conventional photodetector;
FIG. 5 is a diagram illustrating a photodetector according to a second arrangement;
FIG. 6 is a diagram illustrating a photodetector according to a third arrangement;
FIG. 7 is a plan view of a photodetector according to a fourth arrangement;
FIG. 8 is a plan view of the photodetector according to the fourth arrangement;
FIG. 9 is a schematic diagram of the photodetector according to the fourth arrangement;
FIG. 10 is a schematic diagram of a photodetector according to a fifth arrangement;
FIG. 11 is a diagram illustrating a photodetector according to a sixth arrangement;
FIG. 12 is a schematic diagram of the photodetector according to the sixth arrangement;
FIG. 13 is a schematic diagram of a LIDAR device according to a seventh arrangement;
FIG. 14 is an illustration of detection of a detection target by the LIDAR device according to the seventh arrangement; and
FIG. 15 is a top diagram of a movable body according to the seventh arrangement.

### DETAILED DESCRIPTION

### First Arrangement

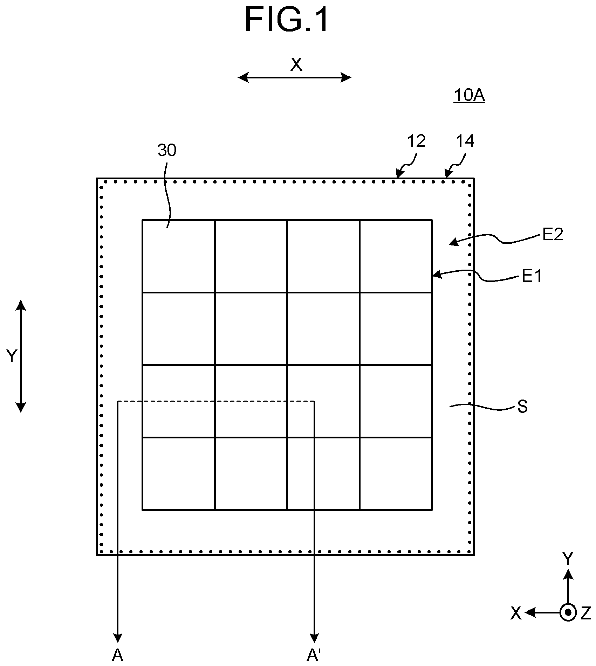

The present arrangement will be described in detail below with reference to the accompanying drawings. FIG. 1 is a diagram illustrating an example of a photodetector 10A.

The photodetector 10A includes a first semiconductor layer 12 and a second semiconductor layer 14.

The first semiconductor layer 12 detects light. The first semiconductor layer 12 is a silicon photomultiplier (SiPM) that is an array of a plurality of avalanche photodiodes (APDs 30) that are light detecting units.

The APDs 30 are avalanche photodiodes including p-n junctions and formed as p-n diodes. In the present arrangement, the APDs 30 are operated in Geiger mode.

A plurality of the APDs 30 is arrayed in a matrix along a first surface S on which light is incident. The first surface S is a light incident surface and is a two-dimensional plane including the arrow X direction and the arrow Y direction in FIG. 1. The arrow X direction and the arrow Y direction are directions orthogonal to each other. The first surface S corresponds to an end surface on the light incident side of the first semiconductor layer 12. The first semiconductor layer 12 may be configured such that one or more APDs 30 form a pixel region of one pixel and a plurality of pixel regions are arrayed in a matrix. "Being arrayed in a matrix" means being arrayed along both the X direction and the Y direction.

The photodetector 10A has a light detection region E1 and a peripheral region E2. The light detection region E1 is a region in which the APDs 30 are arrayed. The peripheral region E2 is a semiconductor region that is provided on the periphery of the light detection region E1 and does not include APDs that are light detecting units.

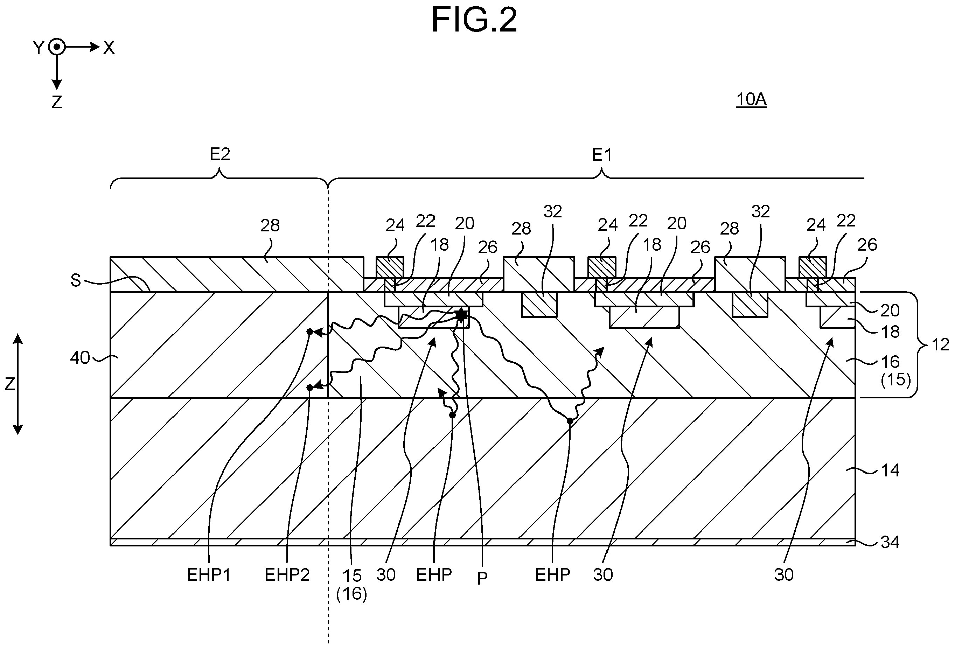

FIG. 2 is a schematic diagram illustrating an example of the photodetector 10A in cross section. FIG. 2 corresponds to A-A' cross section in FIG. 1.

The photodetector 10A is a stack structure in which a common electrode 34, the second semiconductor layer 14, a first semiconductor layer 12, an antireflection coating 26 or an insulating film 28, and a quenching resistor 24 are stacked in this order.

The second semiconductor layer 14 is a semiconductor layer that does not include a light detecting unit. The second semiconductor layer 14 is, for example, a P+ type semiconductor layer. The second semiconductor layer 14 may be any semiconductor layer and may be in the form of a substrate or a film. The second semiconductor layer 14 may be an n type semiconductor layer. In the form of a substrate, for example, the second semiconductor layer 14 may be formed of a Si substrate.

The first semiconductor layer 12 is a semiconductor layer that includes APDs that are light detecting units. That is, the first semiconductor layer 12 is a semiconductor layer in which APDs 30 are arrayed in the light detection region E1. In the present arrangement, the APDs 30 each include a p-n junction formed with a p+ semiconductor layer 18 formed on a p- semiconductor layer 16 and an n+ semiconductor layer 20.

A diode isolation region 32 is formed between APDs 30 in the first semiconductor layer 12. The diode isolation region 32 is a region for isolating adjacent APDs 30 from each other. The diode isolation region 32 is a region continuous to the first surface S of the first semiconductor layer 12. The insulating film 28 is provided on the diode isolation region 32. The insulating film 28 is formed of an insulating material. The insulating film 28 is formed of a material that transmits light incident on the first semiconductor layer 12 and has insulating property.

The antireflection coating 26 is provided on each of a plurality of the APDs 30. The antireflection coating 26 has a structure for preventing reflection of each detection target photon from outside on the surface of the photodetector 10A and for allowing the detection target photon to enter into the APD 30 at high efficiency. The antireflection coating 26 may be made of any material that functions as allowing the entry of a photon at high efficiency. The photodetector 10A does not necessarily have the antireflection coating 26.

The quenching resistor 24 is provided on each of a plurality of the APDs 30 with the antireflection coating 26 interposed. The quenching resistor 24 is connected in series to the APD 30 through a contact layer 22. The quenching resistor 24 serves as a path of electric charge amplified in the APD 30. That is, the quenching resistor 24 is necessary for driving the APD 30 in Geiger mode.

For example, when a photon enters to cause Geiger discharge in the APD 30, a voltage drop due to the quenching resistor 24 terminates the amplifying action. This results in a pulse-like output signal in the APD 30. In the first semiconductor layer 12, each APD 30 has this action. Therefore, when Geiger discharge occurs in a plurality of the APDs 30, the resulting output signal has the quantity of charge or a pulse peak multiplied by the number of APDs 30 subjected to Geiger discharge, compared with the output signal of a single APD 30. Thus, the number of APDs 30 subjected to Geiger discharge, that is, the number of photons incident on the first semiconductor layer 12 can be measured from the output signal, enabling measurement of each individual photons. For example, polysilicon is used for the quenching resistor 24.

The quenching resistor 24 is connected to a signal electrode which is not illustrated. The pulse-like signal output from each APD 30 is output to the signal electrode through the quenching resistor 24.

On the other hand, as described above, the peripheral region E2 is a region that does not include a light detecting unit. In the present arrangement, the peripheral region E2 in the first semiconductor layer 12 includes a first layer region 40. The insulating film 28 is provided on the first layer region 40.

The first layer region 40 is a layer region that is at least a part of the peripheral region E2 in the thickness direction (the arrow Z direction). The layer region is a layer-like region along the XY plane (a plane substantially parallel to the first surface S). The Z direction is a direction orthogonal to the arrow X direction and the arrow Y direction.

FIG. 2 illustrates a mode in which the first layer region 40 occupies the peripheral region E2 of the first semiconductor layer 12. The first layer region 40 may be a layer region that occupies a part of the peripheral region E2 of the first semiconductor layer 12. The first layer region 40 may be a layer region that is at least a part of the first semiconductor layer 12 and the second semiconductor layer 14 in the thickness region of the peripheral region E2 of the photodetector 10A.

The first layer region 40 is, for example, a p+ type semiconductor layer. The first layer region 40 may be an n type semiconductor layer.

The density of a lattice defect in the first layer region 40 is higher than that of a second layer region 15. The second layer region 15 is a layer region adjacent to the first layer region 40 in a direction intersecting the thickness direction Z (the arrow X direction or the arrow Y direction), in the light detection region E1 of the first semiconductor layer 12. In the present arrangement, the second layer region 15 corresponds to the p- semiconductor layer 16 adjacent to the first layer region 40.

The first layer region 40 has a higher density of a lattice defect than the second layer region 15, preferably 1.1 times or higher, more preferably twice or higher.

The lattice defect means a point defect. The density of a lattice defect is implemented by adjusting the amount of radiation of hydrogen (H), helium (He), or electron beams, or the amount of doping of impurities, or the amount of inter-lattice silicon (Si). In the present arrangement, the amount of radiation of helium or electron beams or the amount of doping of impurities is adjusted such that the density of a lattice defect in the first layer region 40 is higher than that of the second layer region 15. The impurities for doping may be identical or may be different between the first layer region 40 and the second layer region 15.

The first layer region 40 may be doped with any impurity that reduces the minority carrier lifetime and the impurity is not limited to impurities for N type or P type. The first layer region 40 is preferably doped with an impurity whose diffusion coefficient in silicon is not large. That is, a first layer region 42 may be doped with an impurity (for example, carbon (C)) that does not function as a carrier or a donor. Specifically, for example, the first layer region 40 is doped with an impurity of at least one or more selected from boron (B), phosphor (P), arsenic (As), antimony (Sb), gallium (Ga), carbon (C), germanium (Ge), gold (Au), platinum (Pt), argon (Ar), krypton (Kr), and xenon (Xe).

The density of a lattice defect is measured by a known method. Examples of the method of measuring the density of a lattice defect include a method of irradiating a tested surface with light (photoluminescence light, electroluminescent light, etc.) and mapping the kinds of crystal defects present in the entire tested surface with density through image analysis, a method of evaluating two-dimensional distribution of crystalline structure defects of a sample in a non-destructive and contactless manner by the photoluminescence method, a method of measuring acoustic wave with an optoacoustic spectrometer, and a method of detecting surface defects from a scattered light image reflected from a tested surface.

The thickness of the first layer region 40 and the position of the first layer region 40 in the thickness direction of the photodetector 10A are not limited. The thickness of the first layer region 40 is the length in the arrow Z direction of the first layer region 40. It is preferable that the thickness of the first layer region 40 and the position of the first layer region 40 in the thickness direction (the arrow Z direction) of the photodetector 10A are as follows. Specifically, it is preferable that the position of the first layer region 40 in the thickness direction of the peripheral region E2 of the photodetector 10A is a position continuous to the first surface S of the first semiconductor layer 12. That is, it is preferable that the first layer region 40 is a region continuous to the first surface S in the peripheral region E2. It is preferable that the thickness of the first layer region 40 is larger than the thickness of the diode isolation region 32 that is a region continuous to the first surface S of the first semiconductor layer 12.

The thickness of the first layer region 40 is, for example, preferably 1.1 times or larger than the thickness of the diode isolation region 32, further preferably twice or larger.

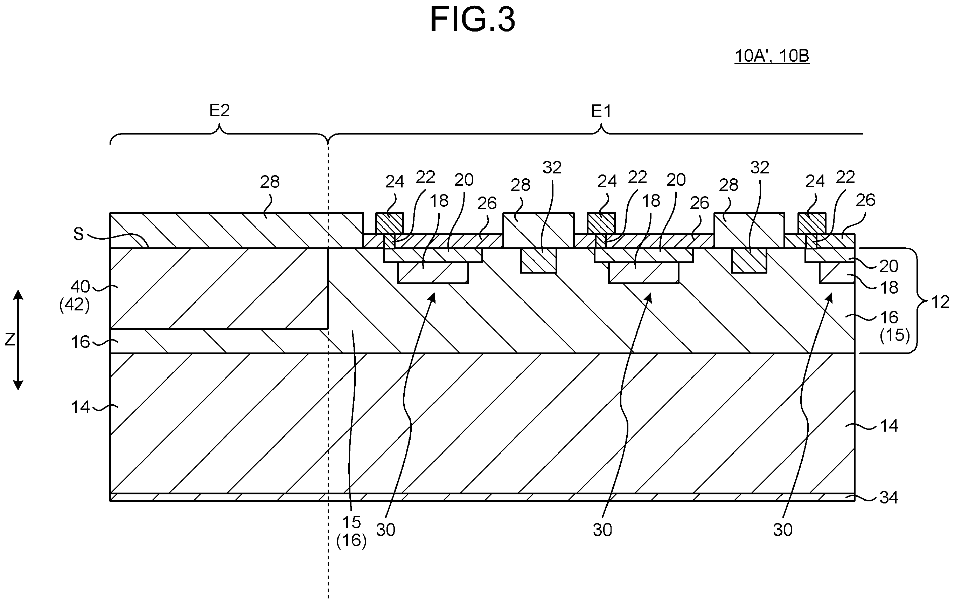

As illustrated in FIG. 2, the first layer region 40 may be a layer that occupies the entire region in the thickness direction (the arrow Z direction) of the peripheral region E2 of the first semiconductor layer 12. Alternatively, the photodetector 10A may have a configuration illustrated in FIG. 3. FIG. 3 is a schematic diagram illustrating an example of a photodetector 10A'. The photodetector 10A' is a modification to the photodetector 10A. The photodetector 10A' has a configuration similar to the photodetector 10A except that the thickness of the first layer region 40 is different.

As illustrated in FIG. 3, the first layer region 40 is a region continuous to the first surface S in the peripheral region E2 and is larger than the thickness of the diode isolation region 32 that is a region continuous to the first surface S of the first semiconductor layer 12. As illustrated in FIG. 3, the peripheral region E2 in the first semiconductor layer 12 may be configured such that the first layer region 40 is stacked on the p- semiconductor layer 16. Returning to FIG. 2, the description continues.

An example of the method of producing the photodetector 10A in the present arrangement will now be described.

First of all, the second semiconductor layer 14 is prepared, and the common electrode 34 is formed on the second semiconductor layer 14. Subsequently, the p- semiconductor layer 16 is formed by epitaxial growth on the surface of the second semiconductor layer 14 on the opposite side to the common electrode 34. The light detection region E1 is then doped with an impurity (for example, boron) such that a part of the p- semiconductor layer 16 becomes the p+ semiconductor layer 18. Then, the n+ semiconductor layer 20 is formed on the p+ semiconductor layer 18 by doping of an impurity. Through these steps, the light detection region E1 of the first semiconductor layer 12 including a plurality of the APDs 30 is formed on the second semiconductor layer 14.

Subsequently, the APDs 30 are isolated such that the APDs 30 do not electrically interfere with each other. The isolation is performed by forming a region between the APDs 30, for example, into a deep trench isolation structure or a channel stopper structure by implantation of an impurity (for example, phosphor). As a result of the isolation, a channel stopper region 28A is formed between the APDs 30.

On the other hand, the first layer region 40 is formed by epitaxial growth in the peripheral region E2 on the second semiconductor layer 14. Here, the amount of radiation of helium (He) or electron beams or the amount of doping of impurities are adjusted such that the density of a lattice defect in the first layer region 40 is higher than that of the p- semiconductor layer 16 that is the second layer region 15.

Subsequently, the insulating film 28 is formed on the first semiconductor layer 12. Subsequently, a region corresponding to a region between adjacent APDs 30 in the insulating film 28 is removed, for example, by etching, and the antireflection coating 26 is formed. For example, the antireflection coating 26 is formed by depositing a nitride film on an oxide film.

Subsequently, the contact layer 22 is formed to electrically connect the APD 30 to the quenching resistor 24, so that the APD 30 is electrically connected to the quenching resistor 24 through the contact layer 22.

Through these steps, the photodetector 10A is produced.

The operation effect of the photodetector 10A in the present arrangement will now be described.

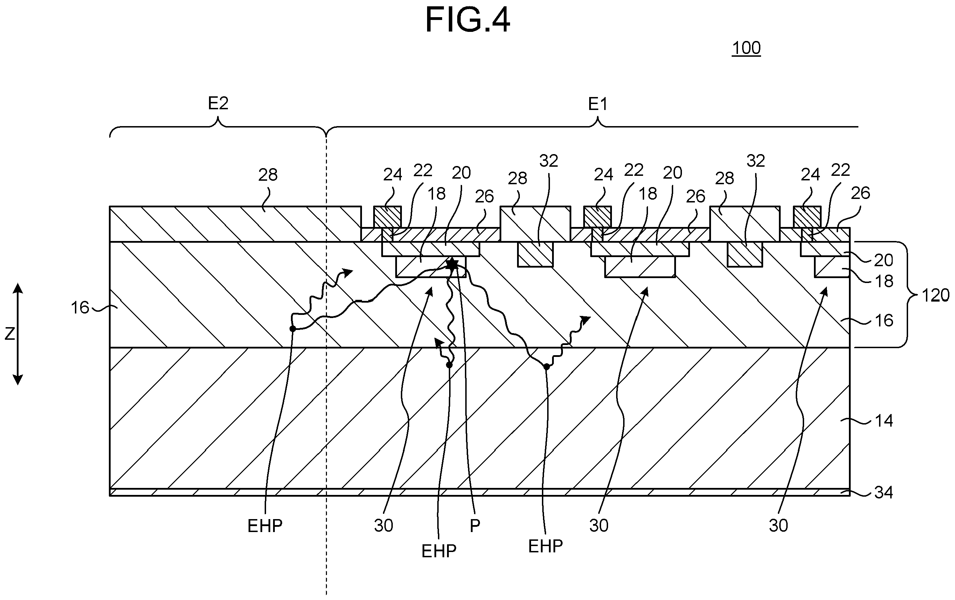

A conventional photodetector 100 is described first. FIG. 4 is a schematic diagram illustrating an example of the conventional photodetector 100. The photodetector 100 includes a comparative first semiconductor layer 120 instead of the first semiconductor layer 12. The comparative first semiconductor layer 120 has a configuration similar to the first semiconductor layer 12 except that the peripheral region E2 is formed with the same p- semiconductor layer 16 as the p- semiconductor layer 16 in the light detection region E1.

When a photon is incident on the APD 30 in the comparative first semiconductor layer 120, secondary photons P are produced due to avalanche breakdown (ABD). The secondary photons P propagate through the surroundings and create electron-hole pairs EHP by excitation. In the conventional photodetector 100, the electron or the hole of the EHP diffuses and reaches the initial APD 30 with a delay of time required for the diffusion, causing ABD again and producing delayed noise called afterpulsing in some cases. Conventionally, when the electron or the hole of the EHP diffuses and reaches the APD 30 different from the initial one with a delay of time required for the diffusion, causing ABD, noise called delayed crosstalk may occur.

Returning to FIG. 2, the description continues. In the photodetector 10A in the present arrangement, suppose that the secondary photon P produced by a photon incident on the APD 30 propagates from the light detection region E1 to the peripheral region E2 in the first semiconductor layer 12.

In the present arrangement, the density of a lattice defect in the first layer region 40 of the peripheral region E2 is higher than the density of a lattice defect in the second layer region 15 (the p- semiconductor layer 16) of the light detection region E1. With this configuration, the first layer region 40 having a higher density of a lattice defect presumably functions as a lifetime killer for minority carriers. Specifically, the electron-hole pairs EHP (in FIG. 2, see EHP1, EHP2) created from the secondary photons P propagating from the light detection region E1 to the peripheral region E2 presumably recombine with the major carriers in the first layer region 40 having a higher density of a lattice defect and disappear. The photodetector 10A in the present arrangement therefore can reduce the minority carrier lifetime and suppress occurrence of noise such as delayed noise and delayed crosstalk.

The photodetector 10A in the present arrangement therefore can suppress occurrence of noise.

### Second Arrangement

In the present arrangement, a mode in which the impurity concentration of the first layer region 40 is adjusted so that the first layer region 40 functions as a lifetime killer for minority carriers will be described.

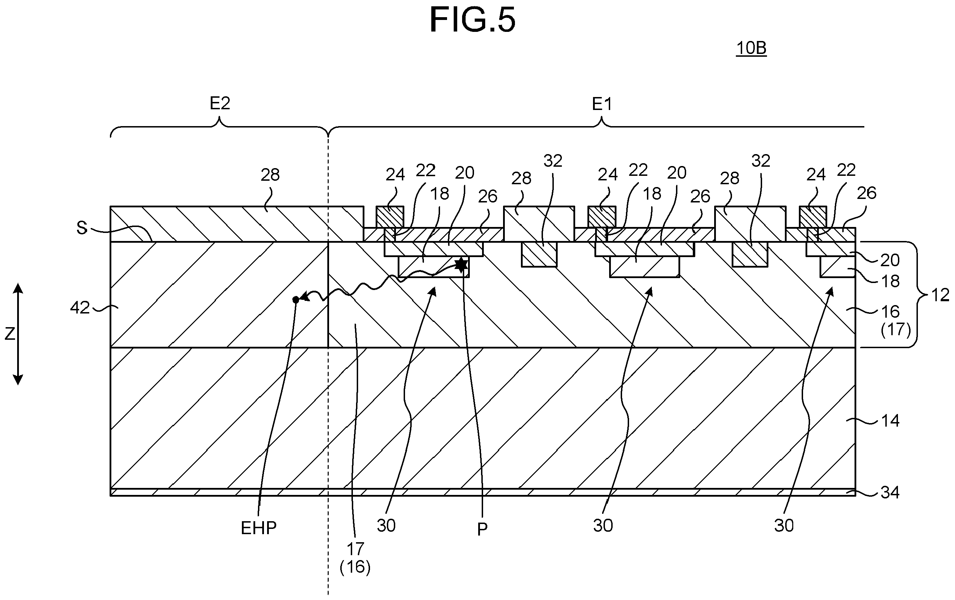

FIG. 5 is a diagram illustrating an example of a photodetector 10B. The photodetector 10B, similar to the photodetector 10A in the foregoing arrangement, includes a first semiconductor layer 12 and the second semiconductor layer 14. The plan view of the photodetector 10B is similar to the photodetector 10A in the foregoing arrangement (see FIG. 1).

The photodetector 10B has a stack configuration in which the second semiconductor layer 14, the first semiconductor layer 12, the antireflection coating 26 or the insulating film 28, and the quenching resistor 24 are stacked in this order on the common electrode 34. The common electrode 34, the second semiconductor layer 14, and the light detection region E1 of the first semiconductor layer 12 are similar to those in the photodetector 10A in the foregoing arrangement.

In the present arrangement, the peripheral region E2 of the first semiconductor layer 12 includes the first layer region 42 instead of the first layer region 40. The first layer region 42 is a semiconductor region that does not include a light detecting unit. The insulating film 28 is stacked on the first layer region 42.

The first layer region 42 is a layer region that is at least a part of the peripheral region E2 in the thickness direction (the arrow Z direction). The definition of the layer region is the same as the foregoing arrangement. FIG. 5 illustrates a mode in which the first layer region 42 occupies the peripheral region E2 in the first semiconductor layer 12, as an example. The first layer region 42 may be a layer region that occupies a part of the peripheral region E2 of the first semiconductor layer 12. The first layer region 42 may be a layer region that is at least a part of the first semiconductor layer 12 and the second semiconductor layer 14 in the thickness region of the peripheral region E2.

The first layer region 42 is, for example, a p+ type semiconductor layer. The first layer region 42 may be an n type semiconductor layer. The concentration of impurity included in the first layer region 42 is higher than the concentration of impurity included in a second layer region 17. The second layer region 17 is a layer region adjacent to the first layer region 42 in a direction intersecting the thickness direction Z (the arrow X direction or the arrow Y direction). In the present arrangement, the second layer region 17 corresponds to the p- semiconductor layer 16 adjacent to the first layer region 42.

As used herein "the concentration of impurity included in the first layer region 42 is higher than that of a second layer region 17" means that the total concentration of one or more kinds of impurities included in the first layer region 42 is higher than the total concentration of one or more kinds of impurities included in the second layer region 17.

The first layer region 42 has a higher concentration of impurity than the second layer region 17, preferably 1.1 times or higher, further preferably twice or higher.

In the present arrangement, the amount of doping of impurities in the first layer region 42 and the second layer region 17 is adjusted such that the concentration of impurity in the first layer region 42 is higher than that of the second layer region 17. The impurities for doping may be identical or may be different between the first layer region 42 and the second layer region 17.

The first layer region 42 may be doped with any impurity that reduces the minority carrier lifetime and the impurity is not limited to impurities for N type or P type. That is, the first layer region 42 may be doped with an impurity (for example, carbon (C)) that does not function as a carrier or a donor. Specifically, for example, the first layer region 42 is doped with an impurity of at least one or more selected from boron (B), phosphor (P), arsenic (As), antimony (Sb), gallium (Ga), carbon (C), germanium (Ge), gold (Au), platinum (Pt), argon (Ar), krypton (Kr), and xenon (Xe).

The concentration of impurity included in the first layer region 42 and the second layer region 17 is measured by a known method. For example, it may be measured by secondary-ion mass spectrometry (SIMS).

The thickness of the first layer region 42 and the position of the first layer region 42 in the thickness direction of the photodetector 10B are not limited. The thickness of the first layer region 42 is the length in the arrow Z direction of the first layer region 42. It is preferable that the thickness of the first layer region 42 and the position of the first layer region 42 in the thickness direction (the arrow Z direction) of the photodetector 10B are as follows. Specifically, it is preferable that the position of the first layer region 42 in the thickness direction of the peripheral region E2 of the photodetector 10B is a position continuous to the first surface S of the first semiconductor layer 12. That is, it is preferable that the first layer region 42 is a region continuous to the first surface S in the peripheral region E2. It is preferable that the thickness of the first layer region 42 is larger than the thickness of the diode isolation region 32 that is a region continuous to the first surface S of the first semiconductor layer 12.

The thickness of the first layer region 42 is, for example, preferably 1.1 times or larger than the thickness of the diode isolation region 32, further preferably twice or larger.

As illustrated in FIG. 5, therefore, the first layer region 42 may be a layer that occupies the entire region in the thickness direction (the arrow Z direction) of the peripheral region E2 of the first semiconductor layer 12. Alternatively, the photodetector 10B may have a configuration illustrated in FIG. 3. As illustrated in FIG. 3, it is preferable that the first layer region 42 is a region continuous to the first surface S in the peripheral region E2 and is larger than the thickness of the diode isolation region 32 that is a region continuous to the first surface S of the first semiconductor layer 12. The peripheral region E2 in the first semiconductor layer 12 may be configured such that the first layer region 42 is stacked on the p-semiconductor layer 16. Returning to FIG. 5, the description continues.

The method of producing the photodetector 10B in the present arrangement is similar to that of the photodetector 10A except that the first layer region 42 is formed by epitaxial growth in the peripheral region E2 on the second semiconductor layer 14. Here, the amount of impurity doping is adjusted such that the impurity concentration in the first layer region 42 is higher than that of the p- semiconductor layer 16 that is the second layer region 17.

The operation effect of the photodetector 10B in the present arrangement will now be described. The description is given with reference to FIG. 5.

In the photodetector 10B in the present arrangement, suppose that a secondary photon P produced by a photon incident on the APD 30 in the first semiconductor layer 12 propagates from the light detection region E1 to the peripheral region E2 in the first semiconductor layer 12. In the present arrangement, the impurity concentration in the first layer region 42 of the peripheral region E2 is higher than that of the second layer region 17 (the p- semiconductor layer 16) of the light detection region E1. With this configuration, the first layer region 42 having a higher impurity concentration presumably functions as a lifetime killer for minority carriers. Specifically, the electron-hole pairs EHP created by secondary photons P propagating from the light detection region E1 to the peripheral region E2 presumably recombine with the major carriers in the first layer region 42 having a higher impurity concentration and disappear. Presumably, the photodetector 10B in the present arrangement therefore can reduce the carrier lifetime of minority carriers and suppress occurrence of noise such as delayed noise and delayed crosstalk.

The photodetector 10B in the present arrangement therefore can suppress occurrence of noise.

### Third Arrangement

In the present arrangement, a mode in which the thickness of the peripheral region E2 is adjusted so that the peripheral region E2 functions as a lifetime killer for minority carriers will be described.

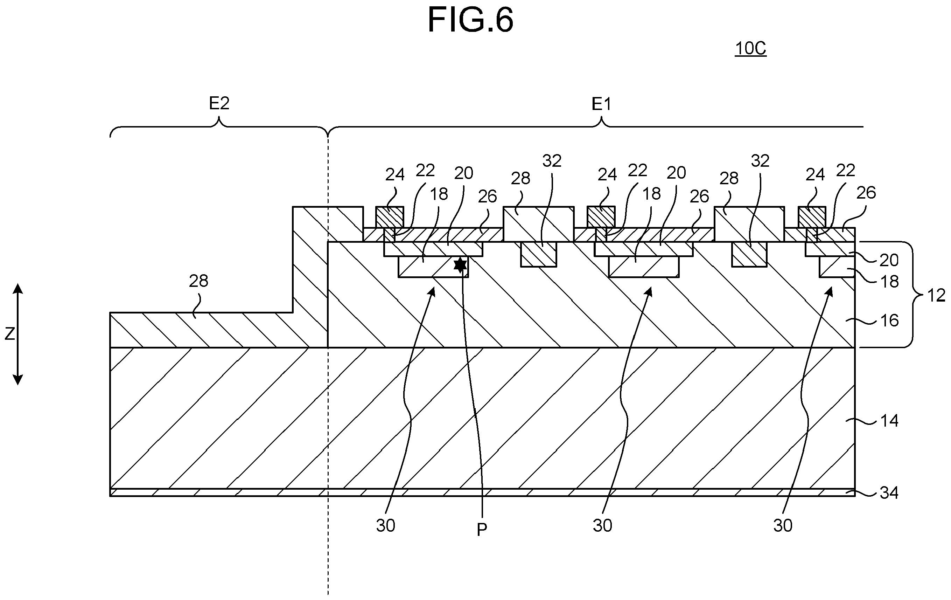

FIG. 6 is a diagram illustrating an example of a photodetector 10C. The photodetector 10C, similar to the photodetector 10A in the foregoing arrangement, includes the first semiconductor layer 12 and the second semiconductor layer 14. The plan view of the photodetector 10C is similar to the photodetector 10A in the foregoing arrangement (see FIG. 1).

The photodetector 10C has a configuration in which the second semiconductor layer 14, the first semiconductor layer 12, the antireflection coating 26 or the insulating film 28, and the quenching resistor 24 are stacked in this order on the common electrode 34. The common electrode 34, the second semiconductor layer 14, and the light detection region E1 of the first semiconductor layer 12 are similar to those in the photodetector 10A in the foregoing arrangement.

In the present arrangement, the thickness of the peripheral region E2 of the first semiconductor layer 12 is smaller than the thickness of the light detection region E1 of the first semiconductor layer 12.

FIG. 6 illustrates a mode in which the peripheral region E2 of the first semiconductor layer 12 does not include a semiconductor layer, as an example. In the photodetector 10C, the peripheral region E2 of the first semiconductor layer 12 may include a semiconductor layer as long as the thickness of the peripheral region E2 of the first semiconductor layer 12 is smaller than the thickness of the light detection region E1 of the first semiconductor layer 12. It is noted that this semiconductor layer is a semiconductor layer that does not include a light detecting unit.

Besides the configuration above, a photodetector 10E may have a configuration that does not further include the second semiconductor layer 14 in the peripheral region E2. In this case, the peripheral region E2 of the photodetector 10C has a configuration, for example, in which the common electrode 34, a glass substrate, and the insulating film 28 are stacked in this order. In this case, the peripheral region E2 of the photodetector 10C does not necessarily have the insulating film 28.

The photodetector 10C in the present arrangement can be produced in the same manner as the photodetector 10A except that the thickness of the peripheral region E2 of the first semiconductor layer 12 is smaller than that of the light detection region E1 of the first semiconductor layer 12.

The operation effect of the photodetector 10C in the present arrangement will now be described.

In the photodetector 10C in the present arrangement, suppose that a secondary photon P produced by a photon incident on the APD 30 in the first semiconductor layer 12 propagates from the light detection region E1 toward the peripheral region E2 in the first semiconductor layer 12. In the present arrangement, the thickness of the peripheral region E2 of the first semiconductor layer 12 is smaller than the thickness of the light detection region E1 of the first semiconductor layer 12. With this configuration, the electron-hole pairs EHP produced from the secondary photons P propagating from the light detection region E1 to the peripheral region E2 presumably reach the APD 30 in the light detection region E1 again. Presumably, the photodetector 10C in the present arrangement therefore can reduce the carrier lifetime of minority carriers and suppress occurrence of noise such as delayed noise and delayed crosstalk.

The photodetector 10C in the present arrangement therefore can suppress occurrence of noise.

### Fourth Arrangement

In the present arrangement, a mode in which the sensitivity of at least one of the APDs 30 arrayed along the circumference of the light detection region E1 is lower than that of the other APDs 30 disposed on the center side so that the APDs 30 with lower sensitivity function as a lifetime killer for minority carriers will be described.

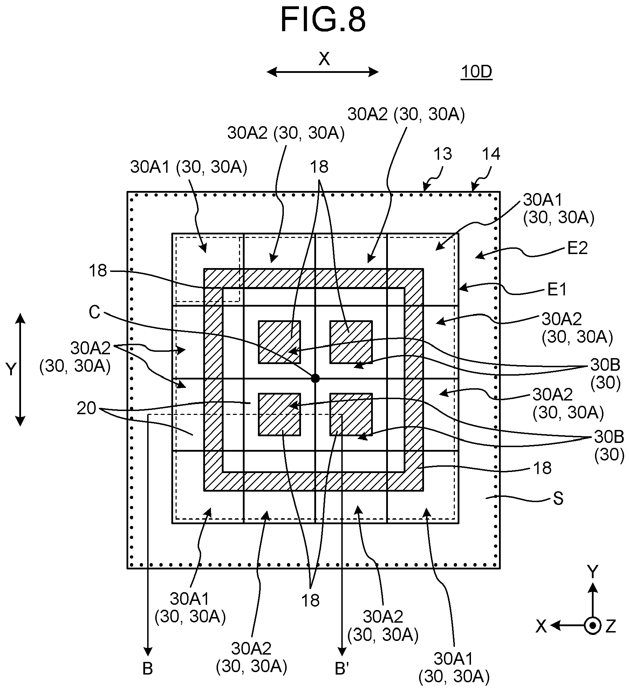

FIG. 8 is a plan view illustrating an example of a photodetector 10D' in the present arrangement.

The photodetector 10D' includes a first semiconductor layer 13 and the second semiconductor layer 14. The second semiconductor layer 14 is similar to that of the first arrangement.

The first semiconductor layer 13 detects light. The first semiconductor layer 13 is a SiPM that is an array of a plurality of the APDs 30 that are light detecting units. The APDs 30 are similar to those in the foregoing arrangements. Similarly to the foregoing arrangements, the APDs 30 are arrayed in a matrix along a first surface S on which light is incident.

The photodetector 10D' has a light detection region E1 and a peripheral region E2 along the first surface S. The definition of the light detection region E1 and the peripheral region E2 is the same as the foregoing arrangements.

In the present arrangement, of a plurality of the APDs 30 arrayed in the light detection region E1, the sensitivity of circumferential APDs 30A is lower than the sensitivity of center APDs 30B that are the other APDs 30 disposed on the center C side of the light detection region E1 relative to the circumferential APDs 30A. The sensitivity means the sensitivity of the APDs 30 to light (photons).

The circumferential APDs 30A are an example of the circumferential light detecting unit. The circumferential APD 30A is at least one of APDs 30 arrayed along the circumference of the light detection region E1. The APDs 30 arrayed along the circumference of the light detection region E1 are a group of APDs 30 arrayed in a row along the circumference of the light detection region E1 in the first surface S1 of the first semiconductor layer 13.

The center C of the light detection region E1 means the center C in a region of the group of APDs 30 arrayed in a matrix along the first surface S.

FIG. 8 illustrates a mode in which the circumferential APDs 30A are a group of APDs 30 arrayed in a row along the circumference of the light detection region E1, as an example. FIG. 8 illustrates a mode in which APDs 30 other than the circumferential APDs 30A in the light detection region E1 are the center APDs 30B, as an example.

In the present arrangement, a mode in which the area in the direction along the first surface S of the p-n junction included in the circumferential APD 30A is smaller than the area in the direction along the first surface S of the p-n junction included in the center APD 30B is described. With this configuration, the sensitivity of the circumferential APDs 30A is lower than that of the center APDs 30B. As used herein "the area in the direction along the first surface S of the p-n junction" means the area in the direction along the first surface S of the interface between the P layer (for example, the p+ semiconductor layer 18) and the N layer (for example, a n+ semiconductor layer 20) that constitute a p-n junction.

In the present arrangement, specifically, the area ratio of the p+ semiconductor layer 18 to the n+ semiconductor layer 20 of the p-n junction included in the circumferential APD 30A is smaller than the area ratio of the p+ semiconductor layer 18 to the n+ semiconductor layer 20 of the p-n junction included in the center APD 30B. As used herein "the area ratio of the p+ semiconductor layer 18 to the n+ semiconductor layer 20" means the ratio of the area of a two-dimensional plane along the first surface S of the p+ semiconductor layer 18 of a p-n junction relative to the area of a two-dimensional plane along the first surface S of the n+ semiconductor layer 20 of the p-n junction.

It is preferable that the position of the p+ semiconductor layer 18 relative to the n+ semiconductor layer 20 of the p-n junction included in the circumferential APD 30A is disposed more toward the center C side, compared with the center APD 30B.

With this configuration, of a plurality of the circumferential APDs 30A, the p+ semiconductor layer 18 of a circumferential APD 30A1 disposed at a corner of the light detection region E1 that is a rectangular region is disposed disproportionately to the center C side. Of a plurality of the circumferential APDs 30A, the p+ semiconductor layer 18 of a circumferential APD 30A2 disposed at a portion other than the corners of the light detection region E1 is disposed disproportionately to the center C side.

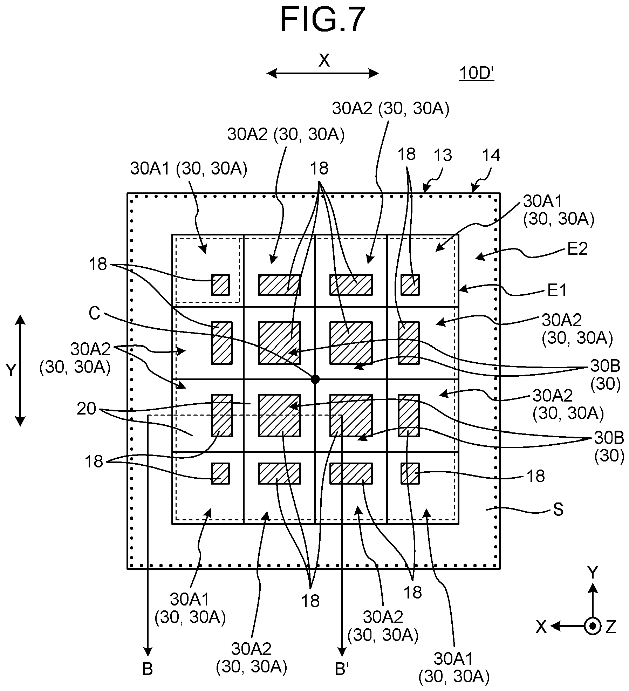

FIG. 7 illustrates an example in which the p+ semiconductor layer 18 included in the circumferential APDs 30A is separate between the circumferential APDs 30A. However, as illustrated in FIG. 8, the photodetector 10D' may be a photodetector 10D configured such that the p+ semiconductor layer 18 included in the circumferential APDs 30A is disposed to be continuous between the circumferential APDs 30A. The photodetector 10D is similar to the photodetector 10D' except that the p+ semiconductor layer 18 included in the circumferential APDs 30A is disposed to be continuous between the circumferential APDs 30A. The photodetector 10D will be described below as an example.

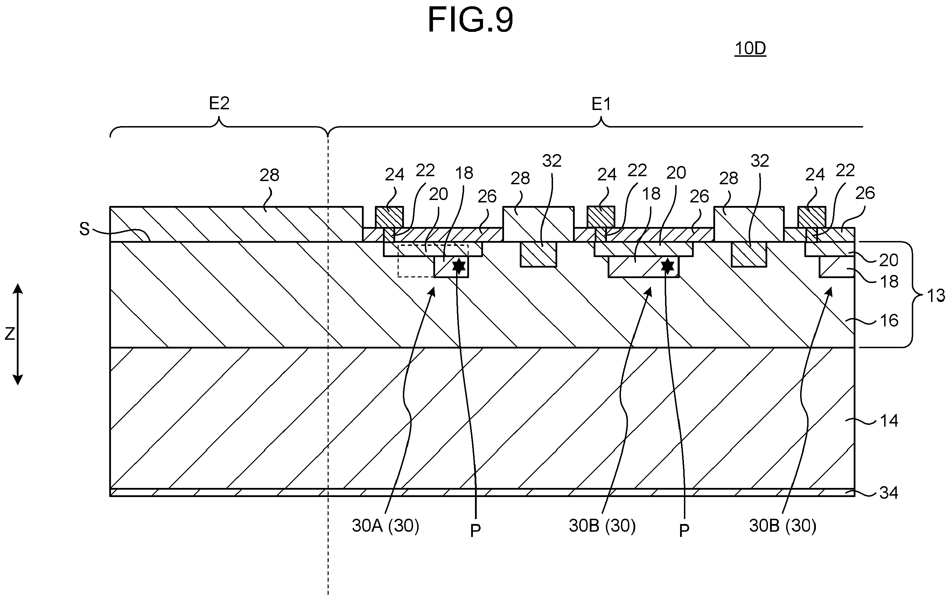

FIG. 9 is a schematic diagram illustrating an example of the photodetector 10D in cross section. FIG. 9 corresponds to B-B' cross section in FIG. 8.

As illustrated in FIG. 9, the area ratio of the p+ semiconductor layer 18 to the n+ semiconductor layer 20 of the p-n junction included in the circumferential APD 30A is smaller than the area ratio of the p+ semiconductor layer 18 to the n+ semiconductor layer 20 of the p-n junction included in the center APD 30B.

The area ratio of the circumferential APD 30A is smaller than the area ratio of the center APD 30B. Preferably, the area ratio of the circumferential APD 30A is equal to or smaller than 9/10, further preferably equal to or smaller than 1/2 of the area ratio of the center APD 30B.

As illustrated in FIG. 9, it is preferable that the position of the p+ semiconductor layer 18 relative to the n+ semiconductor layer 20 of the p-n junction included in the circumferential APD 30A is disposed disproportionately to the center C side, compared with the center APD 30B.

The method of producing the photodetector 10D in the present arrangement is similar to that of the photodetector 10A except that the APDs 30 are formed such that the area in the direction along the first surface S of the p-n junction included in the circumferential APD 30A is smaller than the area in the direction along the first surface S of the p-n junction included in the center APD 30B.

The operation effect of the photodetector 10D in the present arrangement will now be described.

In the photodetector 10D in the present arrangement, suppose that a secondary photon P produced by a photon incident on the APD 30 in the first semiconductor layer 13 propagates from the light detection region E1 toward the peripheral region E2 in the first semiconductor layer 12. In the present arrangement, the sensitivity of the circumferential APD 30A that is at least one APD 30 arrayed along the circumference of the light detection region E1 is smaller than that of the center APD 30B.

This configuration presumably suppresses propagation of secondary photons P from the light detection region E1 toward the peripheral region E2. Presumably, the photodetector 10D in the present arrangement therefore can reduce the carrier lifetime of minority carriers and suppress occurrence of noise such as delayed noise and delayed crosstalk.

The photodetector 10D in the present arrangement therefore can suppress occurrence of noise.

### Fifth Arrangement

In the present arrangement, a mode in which the impurity concentration of the p-n junction included in the circumferential APD 30A is adjusted so that the sensitivity of the circumferential APD 30A is lower than that of the center APD 30B will be described.

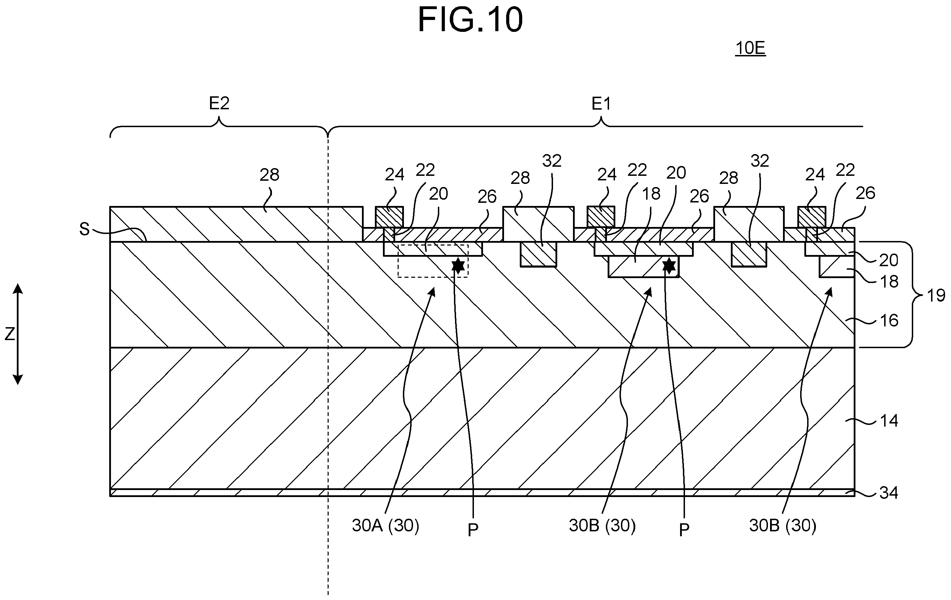

FIG. 10 is a diagram illustrating an example of the photodetector 10E in the present arrangement. The photodetector 10E includes a first semiconductor layer 19 and the second semiconductor layer 14. The second semiconductor layer 14 is similar to that of the first arrangement. The plan view of the photodetector 10E is similar to the photodetector 10D in the foregoing arrangement (see FIG. 8).

The first semiconductor layer 19 detects light. The first semiconductor layer 19 is a SiPM that is an array of a plurality of the APDs 30 that are light detecting units. The APDs 30 are similar to those in the foregoing arrangements. Similarly to the foregoing arrangements, the APDs 30 are arrayed in a matrix along a first surface S on which light is incident.

The photodetector 10E has a light detection region E1 and a peripheral region E2 along the first surface S. The definition of the light detection region E1 and the peripheral region E2 is the same as the foregoing arrangements.

In the present arrangement, of a plurality of the APDs 30 arrayed in the light detection region E1, the sensitivity of the circumferential APDs 30A is lower than that of the center APDs 30B disposed on the center C side of the light detection region E1 relative to the circumferential APDs 30A. The definition of the circumferential APDs 30A and the center APDs 30B is the same as the foregoing arrangement.

In the present arrangement, the impurity concentration of at least one of the p+ semiconductor layer 18 and the n+ semiconductor layer 20 of the p-n junction included in the circumferential APD 30A is lower than the impurity concentration of at least one of the p+ semiconductor layer 18 and the n+ semiconductor layer 20 of the p-n junction included in the center APD 30B.

As an example, FIG. 10 illustrates a mode in which the p-n junction of the circumferential APD 30A is formed with the p- semiconductor layer 16 and the n+ semiconductor layer 20 and the p-n junction of the center APD 30B is formed with the p+ semiconductor layer 18 and the n+ semiconductor layer 20.

In the photodetector 10E, the impurity concentration of at least one of the p layer and the n layer of the p-n junction included in the circumferential APD 30A is lower than the impurity concentration of at least one of the p layer and the n layer of the p-n junction included in the center APD 30B. The kinds of impurities included in the circumferential APD 30A and the center APD 30B are not limited.

For example, the impurity concentration of at least one of the p layer and the n layer of the p-n junction included in the circumferential APD 30A is equal to lower than 9/10, further preferably equal to or lower than 1/2 of the impurity concentration of at least one of the p layer and the n layer of the p-n junction included in the center APD 30B.

The method of producing the photodetector 10E in the present arrangement is similar to that of the photodetector 10A except that the APDs 30 are formed such that the impurity concentration of the p-n junction included in the circumferential APD 30A is lower than the impurity concentration of the p-n junction included in the center APD 30B.

The operation effect of the photodetector 10E in the present arrangement will now be described.

In the photodetector 10E in the present arrangement, suppose that a secondary photon P produced by a photon incident on the APD 30 in the first semiconductor layer 19 propagates from the light detection region E1 toward the peripheral region E2 in the first semiconductor layer 19. In the present arrangement, the sensitivity of the circumferential APD 30A that is at least one APD 30 arrayed along the circumference of the light detection region E1 is lower than that of the center APD 30B.

This configuration presumably suppresses propagation of secondary photons P from the light detection region E1 to toward the peripheral region E2. Presumably, the photodetector 10E in the present arrangement therefore can reduce the carrier lifetime of minority carriers and suppress occurrence of noise such as delayed noise and delayed crosstalk.

The photodetector 10E in the present arrangement therefore can suppress occurrence of noise.

### Sixth Arrangement

In the present arrangement, a mode in which at least a part of the light incident surface of the circumferential APD 30A is covered with a light-shielding film so that the sensitivity of the circumferential APD 30A is lower than that of the center APD 30B will be described.

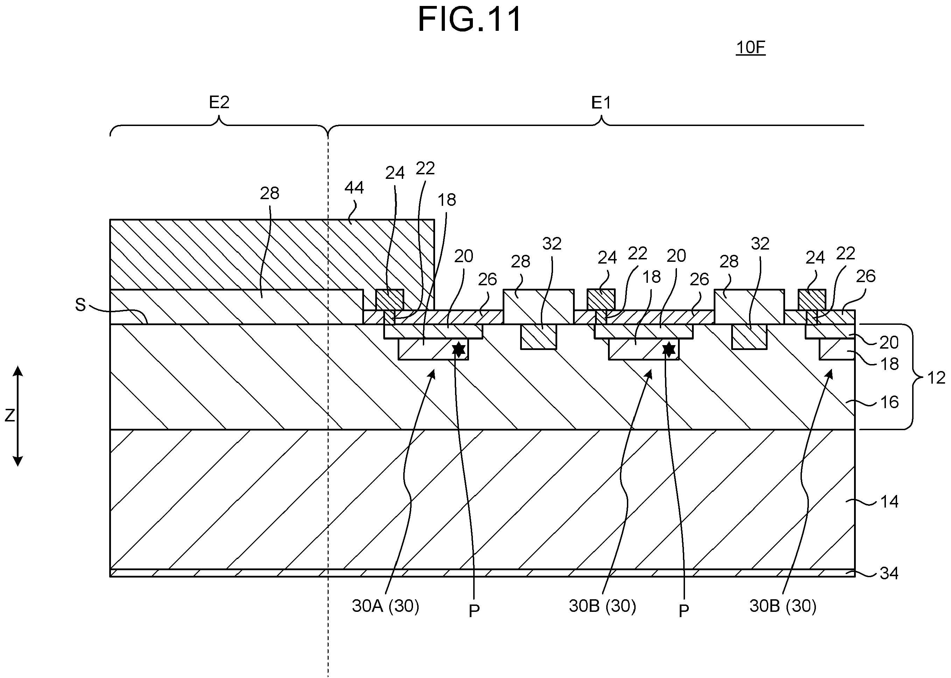

FIG. 11 is a diagram illustrating an example of a photodetector 10F in the present arrangement. The photodetector 10F includes the first semiconductor layer 12, the second semiconductor layer 14, and a light-shielding film 44. The photodetector 10F is a stack structure in which the common electrode 34, the second semiconductor layer 14, the first semiconductor layer 12, the antireflection coating 26 or the insulating film 28, the quenching resistor 24, and the light-shielding film 44 are stacked in this order. The common electrode 34, the second semiconductor layer 14, the first semiconductor layer 12, the quenching resistor 24, the antireflection coating 26, and the insulating film 28 are similar to those in the first arrangement.

The light-shielding film 44 is disposed on at least a part of the light incident surface in the circumferential APD 30A that is at least one of APDs 30 arrayed along the circumference of the light detection region E1. The definition of the circumferential APD 30A is the same as the foregoing arrangement.

FIG. 11 illustrates a mode in which the light-shielding film 44 is disposed to cover a part of the light incident surface of the circumferential APD 30A, as an example. The light incident surface of the circumferential APD 30A corresponds to the first surface S of the circumferential APD 30A.

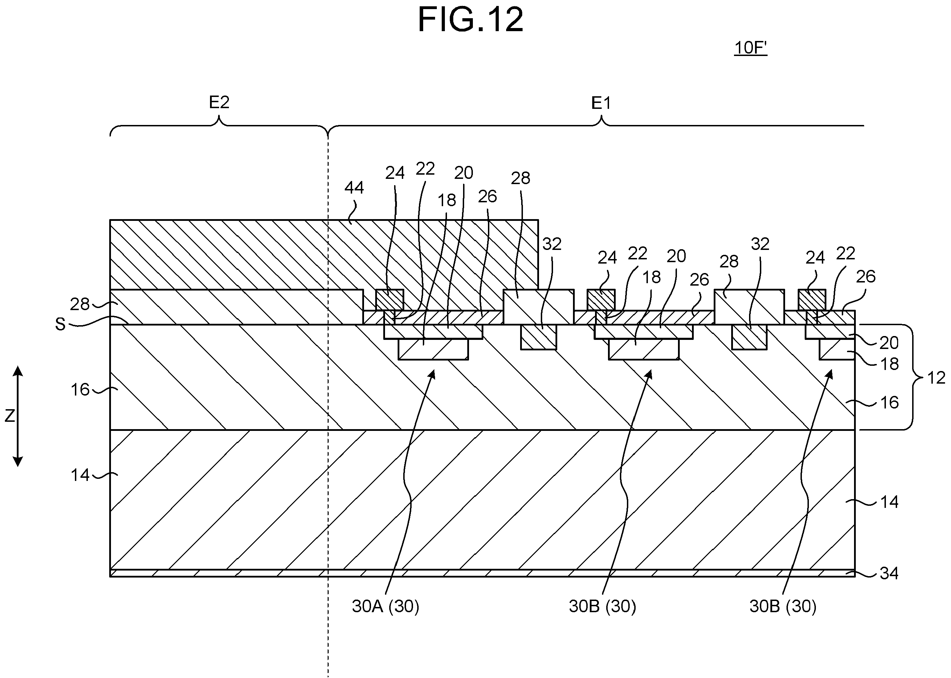

It is preferable that the light-shielding film 44 is further disposed on at least a part of the light incident surface of the peripheral region E2, as illustrated in a photodetector 10F' in FIG. 12. FIG. 12 is a schematic diagram illustrating an example of the photodetector 10F'. The photodetector 10F' has a configuration similar to the photodetector 10F except that the position of the light-shielding film 44 is different.

As illustrated in FIG. 12, it is preferable that the light-shielding film 44 is disposed to cover at least a part of the circumferential APD 30A in the light detection region E1 continuously from the peripheral region E2 in the light incident surface of the first semiconductor layer 12.

The light-shielding film 44 is formed of a material that blocks light to which the APDs 30 have sensitivity. When the light-shielding film 44 has electrical conductivity, an insulating film is provided between the light-shielding film 44 and the signal electrode and/or the quenching resistor. The light-shielding film 44 is formed, for example, of a material including at least one selected from aluminum, copper, and carbon black.

The method of producing the photodetector 10F is similar to that of the photodetector 10A in the foregoing arrangement except that the light-shielding film 44 is further provided in the photodetector 10A.

The operation effect of the photodetector 10F in the present arrangement will now be described. The description is given with reference to FIG. 11.

In the photodetector 10F in the present arrangement, suppose that a secondary photon P produced by a photon incident on the APD 30 in the first semiconductor layer 12 propagates from the light detection region E1 toward the peripheral region E2 in the first semiconductor layer 12. In the present arrangement, the light-shielding film 44 is provided on the circumferential APD 30A that is at least one APD 30 arrayed along the circumference of the light detection region E1. With this configuration, the sensitivity of the circumferential APD 30A is lower than that of the center APD 30B.

This configuration presumably suppresses propagation of secondary photons P from the light detection region E1 toward the peripheral region E2. Presumably, the photodetector 10F in the present arrangement therefore can reduce EHPs produced by secondary photons P in the peripheral region E2 and can suppress occurrence of delayed noise such as delayed crosstalk.

The photodetector 10F in the present arrangement therefore can suppress occurrence of noise.

The photodetector 10A to the photodetector 10F according to the foregoing arrangements and other elements such as transistor, diode, resistor, and capacitor may be formed on the same silicon substrate to produce a silicon on chip (SOC).

The configuration of the photodetector 10F in the present arrangement may be combined with the configuration of the photodetector 10D' or the photodetector 10D described in the foregoing fourth arrangement. Specifically, the photodetector 10F in the present arrangement may be configured such that, of a plurality of the APDs 30 arrayed in the light detection region E1, the sensitivity of the circumferential APDs 30A is lower than the sensitivity of the center APDs 30B that are the other APDs 30 arranged on the center C side of the light detection region E1 relative to the circumferential APDs 30A. Here, there is a possibility that avalanche is caused by carriers even in a region shielded by the light-shielding film 44. The possibility of causing avalanche can be reduced by combining the configuration of the photodetector 10F in the present arrangement with the configuration of the photodetector 10D' or the photodetector 10D. Such a combined configuration can further reduce noise and can further increase reliability.

### Seventh Arrangement

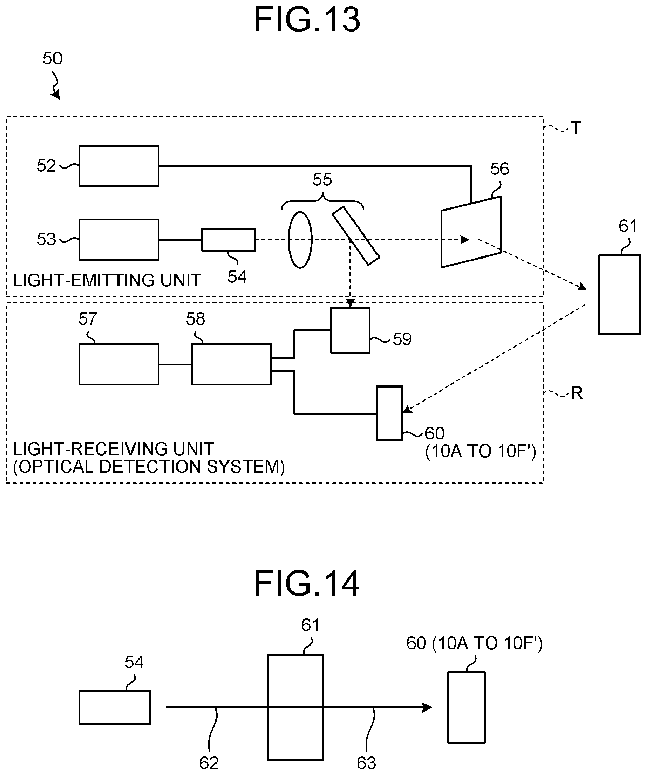

FIG. 13 is a schematic diagram illustrating a laser imaging detection and ranging (LIDAR) device 50 according to the present arrangement.

The LIDAR device 50 is configured with a line light source and a lens and is applicable to a long-distance subject sensing system (LIDAR), for example. The LIDAR device 50 includes a light-emitting unit T projecting laser light to a target 61 and a light-receiving unit R (also referred to as optical detection system) receiving laser light from the target 61 and measuring the time taken for laser light to travel to and from the target 61 and converting the time into a distance.

In the light-emitting unit T, a laser oscillator 54 emits laser light. The laser oscillator 54 may be referred to as a light source. A drive circuit 53 drives the laser oscillator 54. An optical system 55 extracts part of laser light as reference light and irradiates the target 61 with the remaining laser light through a mirror 56. A mirror controller 52 controls the mirror 56 to project laser light onto the target 61. Projecting light means applying light.

In the light-receiving unit R, a reference light detector 59 detects the reference light extracted by the optical system 55. A light detector 60 receives reflected light from the target 61. A distance measuring circuit 58 measures the distance to the target 61, based on the reference light detected by the reference light detector 59 and the reflected light detected by the light detector 60. An image recognition system 57 recognizes the target 61, based on the result measured by the distance measuring circuit 58.

The LIDAR device 50 employs the time-of-flight (ToF) method that measures the time taken for laser light to travel to and from the target 61 and coverts the measured time into a distance. The LIDAR device 50 is applied to on-vehicle drive assist systems, remote sensing, etc. The photodetector 10A to the photodetector 10F' in the foregoing arrangements are used as the light detector 60 to achieve high sensitivity particularly in the near infrared region. The LIDAR device 50 therefore can be applied to a light source in wavelength bandwidths invisible to humans. The LIDAR device 50 can be used, for example, for obstacle detection for vehicles.

FIG. 14 is an illustration of detection of a detection target by the LIDAR device 50.

The laser oscillator 54 serving as a light source emits light 62 to the target 61 to be detected. The light detector 60 detects light 63 transmitted through or reflected by the target 61 or diffused.

The photodetector 10A to the photodetector 10F' according to the foregoing arrangements can be used as the light detector 60 to achieve accurate detection with less noise. It is preferable that a plurality of sets of the light detector 60 and the laser oscillator 54 are provided and their positional relation is set in software (alternatively, circuit) in advance. It is preferable that the sets of the light detector 60 and the laser oscillator 54 are provided, for example, at regular intervals. Thus, output signals of the light detectors 60 can be complemented with each other, thereby generating a precise three-dimensional image.

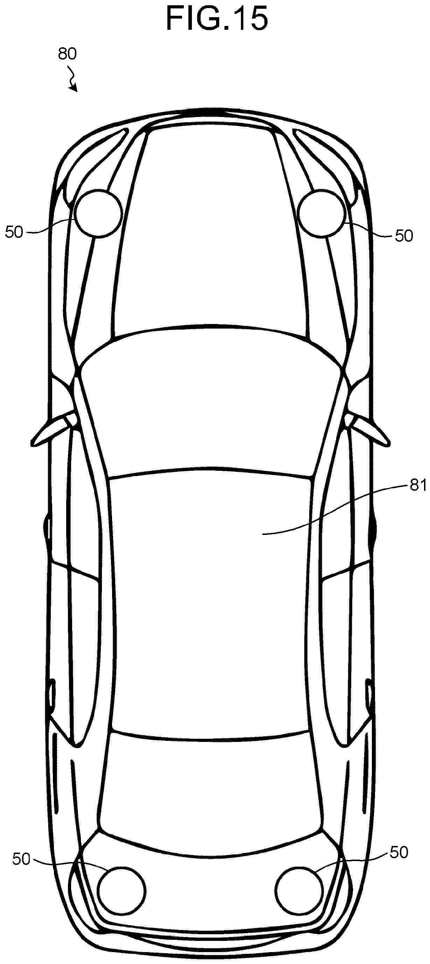

FIG. 15 is a top diagram of a movable body 80 having the LIDAR device 50 according to the present arrangement.

The movable body 80 is an object capable of moving. Examples of the movable body 80 include vehicles (motorcycles, automobiles, bicycles), carriages, robots, ships, and flying objects (airplanes, unmanned aerial vehicles (UAVs), and drones). The movable body 80 is, for example, a movable body traveling through human driving operation or may be a movable body capable of autonomous driving (self-driving) without human driving operation. The movable body capable of autonomous driving is, for example, an autonomous car. The movable body 80 in the present arrangement is a vehicle capable of self-driving, as an example.

The movable body 80 has the LIDAR devices 50 at four corners of a vehicle body 81. Because of the LIDAR devices 50 installed at four corners of the vehicle body 81, the movable body 80 according to the present arrangement can accurately detect the surroundings of the movable body 80 in all directions with the LIDAR devices 50.

While certain arrangements have been described, these arrangements have been presented by way of example only, and are not intended to limit the scope of the claims. Indeed, the apparatuses described herein may be embodied in a variety of other forms; furthermore various omissions, substitutions and changes in the form of the apparatuses described herein may be made.
Example 1. According to an arrangement, a photodetector (10A, 10A', 10B, 10C, 10D, 10E, 10F, 10F') includes a first semiconductor layer (12, 19) including a light detection region (E1) and a peripheral region (E2) on a first surface on which light is incident. The light detection region (E1) is a region in which a plurality of light detecting units (30) is arrayed. The peripheral region (E2) is a semiconductor region disposed on a periphery of the light detection region (E1), without a light detecting unit (30). A density of a lattice defect in a first layer region (40) that is at least a part in a thickness direction of the peripheral region (E2) is higher than a density of a lattice defect in a second layer region adjacent to the first layer region (40) in a direction intersecting the thickness direction in the light detection region.
Example 2. According to an arrangement, a photodetector (10A, 10A', 10B, 10C, 10D, 10E, 10F, 10F') includes a first semiconductor layer (12, 19) including a light detection region (E1) and a peripheral region (E2) on a first surface on which light is incident. The light detection region (E1) is a region in which a plurality of light detecting units (30) is arrayed. The peripheral region (E2) is a semiconductor region disposed on a periphery of the light detection region (E1), without a light detecting unit (30). A concentration of impurity included in a first layer region (40) that is at least a part in a thickness direction of the peripheral region (E2) is higher than a concentration of impurity included in a second layer region (15, 17) adjacent to the first layer region (40) in a direction intersecting the thickness direction in the light detection region (E1).
Example 3. In photodetector (10A, 10A', 10B, 10C, 10D, 10E, 10F, 10F') according to example 2, the impurity includes a certain impurity that shortens minority carrier lifetime.
Example 4. In photodetector (10A, 10A', 10B, 10C, 10D, 10E, 10F, 10F') according to any one of example s 1 to 3, the light detection region (E1) has a diode isolation region (32) between the light detecting units (30) adjacent to each other. The first layer region (40) and the diode isolation region (32) are continuous to the first surface. A thickness of the first layer region (40) is larger than a thickness of the diode isolation region (32).
Example 5. Photodetector (10A, 10A', 10B, 10C, 10D, 10E, 10F, 10F') according to any one of examples 1 to 4 further includes a second semiconductor layer (14) on which the first semiconductor layer (12, 19) is stacked, the second semiconductor layer (14) not including the light detecting unit (30), and a layer region of at least a part of the first semiconductor layer (12, 19) and the second semiconductor layer (14) in a thickness direction of the peripheral region (E2) is the first layer region (40).
Example 6. According to an arrangement, a photodetector (10A, 10A', 10B, 10C, 10D, 10E, 10F, 10F') includes a first semiconductor layer (12, 19) including a light detection region (E1) and a peripheral region (E2) on a first surface on which light is incident. The light detection region (E1) is a region in which a plurality of light detecting units (30) is arrayed. The peripheral region (E2) is a semiconductor region disposed on a periphery of the light detection region (E1), without a light detecting unit (30). A thickness of the peripheral region (E2) in the first semiconductor layer (12, 19) is smaller than a thickness of the light detection region (E1).
Example 7. According to an arrangement, a photodetector (10A, 10A', 10B, 10C, 10D, 10E, 10F, 10F') includes a first semiconductor layer (12, 19) including a light detection region (E1) and a peripheral region (E2) on a first surface on which light is incident. The light detection region (E1) is a region in which a plurality of light detecting units (30) is arrayed. The peripheral region (E2) is a semiconductor region disposed on a periphery of the light detection region (E1), without a light detecting unit (30). A circumferential light detecting unit (30A) that is at least one of the light detecting units (30) arrayed along a circumference of the light detection region (E1) has sensitivity lower than that of a center light detecting unit (30B) that is another light detecting unit disposed on a center side of the light detection region (E1) relative to the circumferential light detecting unit (30A).
Example 8. In photodetector (10A, 10A', 10B, 10C, 10D, 10E, 10F, 10F') according to example 7, an area in a direction along the first surface of a p-n junction included in the circumferential light detecting unit (30A) is smaller than an area of a p-n junction included in the center light detecting unit (30B).
Example 9. In photodetector (10A, 10A', 10B, 10C, 10D, 10E, 10F, 10F') according to example 7 or 8, an area ratio of a p layer to an n layer of a p-n junction included in the circumferential light detecting unit (30A) is smaller than an area ratio of a p layer to an n layer of a p-n junction included in the center light detecting unit (30B), and a position of a p layer relative to an n layer of a p-n junction included in the circumferential light detecting unit (30A) is disposed more toward a center side, compared with the center light detecting unit (30B).
Example 10. In photodetector (10A, 10A', 10B, 10C, 10D, 10E, 10F, 10F') according to example 7, a concentration of impurity included in at least one of a p layer and an n layer of a p-n junction included in the circumferential light detecting unit (30A) is lower than a concentration of impurity included in at least one of a p layer and an n layer of a p-n junction included in the center light detecting unit (30B).
Example 11. According to an arrangement, a photodetector (10A, 10A', 10B, 10C, 10D, 10E, 10F, 10F') includes a first semiconductor layer (12, 19) including a light detection region (E1) and a peripheral region (E2) on a first surface on which light is incident. The light detection region (E1) is a region in which a plurality of light detecting units (30) is arrayed. The peripheral region (E2) is a semiconductor region disposed on a periphery of the light detection region (E1), without a light detecting unit (30). Additionally, photodetector (10A, 10A', 10B, 10C, 10D, 10E, 10F, 10F') includes a light-shielding film (44) disposed on at least a part of a light incident surface in a circumferential light detecting unit (30A) that is at least one of the light detecting units (30) arrayed along a circumference of the light detection region (E1).
Example 12. In photodetector (10A, 10A', 10B, 10C, 10D, 10E, 10F, 10F') according to example 11, the circumferential light detecting unit (30A) has sensitivity lower than that of a center light detecting unit (30B) that is another light detecting unit disposed on a center side of the light detection region (E1) relative to the circumferential light detecting unit (30A).
Example 13. In photodetector (10A, 10A', 10B, 10C, 10D, 10E, 10F, 10F') according to example 11 or 12, the light-shielding film (44) is further disposed on at least a part of a light incident surface of the peripheral region (E2).
Example 14. According to an arrangement, an optical detection system (R) includes photodetector (10A, 10A', 10B, 10C, 10D, 10E, 10F, 10F') according to any one of examples 1 to 13; and a distance measuring unit (58) configured to measure a distance from an output signal of photodetector (10A, 10A', 10B, 10C, 10D, 10E, 10F, 10F') to a target (61).
Example 15. According to an arrangement, a laser imaging detection and ranging (LIDAR) device (50) includes a light source (54) configured to irradiate an object with light; and the optical detection system (R) according to example 14 configured to detect light reflected by the object.
Example 16. According to an arrangement, a movable body (80) includes the laser imaging detection and ranging (LIDAR) device (50) according to example 15.

## Claims

1. A photodetector (10A, 10A', 10B, 10C, 10D, 10E, 10F, 10F') comprising:
a first semiconductor layer (12, 19) including a light detection region (E1) and a peripheral region (E2) on a first surface on which light is incident, the light detection region (E1) being a region in which a plurality of light detecting units (30) are arrayed, the peripheral region (E2) being a semiconductor region disposed on a periphery of the light detection region (E1) and not including a light detecting unit (30), wherein
a density of a lattice defect in a first layer region (40) that is at least a part in a thickness direction of the peripheral region (E2) is higher than a density of a lattice defect in a second layer region adjacent to the first layer region (40) in a direction intersecting the thickness direction in the light detection region.

2. The photodetector (10A, 10A', 10B, 10C, 10D, 10E, 10F, 10F') according to claim 1, wherein
a concentration of impurity included in a first layer region (40) that is at least a part in a thickness direction of the peripheral region (E2) is higher than a concentration of impurity included in a second layer region (15, 17) adjacent to the first layer region (40) in a direction intersecting the thickness direction in the light detection region (E1).

3. The photodetector (10A, 10A', 10B, 10C, 10D, 10E, 10F, 10F') according to claim 2, wherein the impurity includes a certain impurity that shortens minority carrier lifetime.

4. The photodetector (10A, 10A', 10B, 10C, 10D, 10E, 10F, 10F') according to any one of claims 1 to 3, wherein
the light detection region (E1) has a diode isolation region (32) between the light detecting units (30) adjacent to each other,
the first layer region (40) and the diode isolation region (32) are continuous to the first surface, and
a thickness of the first layer region (40) is larger than a thickness of the diode isolation region (32).

5. The photodetector (10A, 10A', 10B, 10C, 10D, 10E, 10F, 10F') according to any one of claims 1 to 4, further comprising:
a second semiconductor layer (14) on which the first semiconductor layer (12, 19) is stacked, the second semiconductor layer (14) not including the light detecting unit (30), and
a layer region of at least a part of the first semiconductor layer (12, 19) and the second semiconductor layer (14) in a thickness direction of the peripheral region (E2) is the first layer region (40).

6. The photodetector (10A, 10A', 10B, 10C, 10D, 10E, 10F, 10F') according to claim 1, wherein
a thickness of the peripheral region (E2) in the first semiconductor layer (12, 19) is smaller than a thickness of the light detection region (E1).

7. The photodetector (10A, 10A', 10B, 10C, 10D, 10E, 10F, 10F') according to claim 1, wherein
a circumferential light detecting unit (30A) that is at least one of the light detecting units (30) arrayed along a circumference of the light detection region (E1) has sensitivity lower than that of a center light detecting unit (30B) that is another light detecting unit disposed on a center side of the light detection region (E1) relative to the circumferential light detecting unit (30A).

8. The photodetector (10A, 10A', 10B, 10C, 10D, 10E, 10F, 10F') according to claim 7, wherein
an area in a direction along the first surface of a p-n junction included in the circumferential light detecting unit (30A) is smaller than an area of a p-n junction included in the center light detecting unit (30B).

9. The photodetector (10A, 10A', 10B, 10C, 10D, 10E, 10F, 10F') according to claim 7 or 8, wherein
an area ratio of a p layer to an n layer of a p-n junction included in the circumferential light detecting unit (30A) is smaller than an area ratio of a p layer to an n layer of a p-n junction included in the center light detecting unit (30B), and a position of a p layer relative to an n layer of a p-n junction included in the circumferential light detecting unit (30A) is disposed more toward a center side, compared with the center light detecting unit (30B).

10. The photodetector (10A, 10A', 10B, 10C, 10D, 10E, 10F, 10F') according to claim 7, wherein
a concentration of impurity included in at least one of a p layer and an n layer of a p-n junction included in the circumferential light detecting unit (30A) is lower than a concentration of impurity included in at least one of a p layer and an n layer of a p-n junction included in the center light detecting unit (30B).

11. The photodetector (10A, 10A', 10B, 10C, 10D, 10E, 10F, 10F') according to claim 1, further comprising:
a light-shielding film (44) disposed on at least a part of a light incident surface in a circumferential light detecting unit (30A) that is at least one of the light detecting units (30) arrayed along a circumference of the light detection region (E1).

12. The photodetector (10A, 10A' , 10B, 10C, 10D, 10E, 10F, 10F') according to claim 11, wherein
the circumferential light detecting unit (30A) has sensitivity lower than that of a center light detecting unit (30B) that is another light detecting unit disposed on a center side of the light detection region (E1) relative to the circumferential light detecting unit (30A).

13. The photodetector (10A, 10A', 10B, 10C, 10D, 10E, 10F, 10F') according to claim 11 or 12, wherein
the light-shielding film (44) is further disposed on at least a part of a light incident surface of the peripheral region (E2).

14. The photodetector (10A, 10A', 10B, 10C, 10D, 10E, 10F, 10F') according to any one of claims 1 to 13 included in an optical detection system (R), the optical detection system (R) comprising:
a distance measuring unit (58) configured to measure a distance from an output signal of photodetector (10A, 10A', 10B, 10C, 10D, 10E, 10F, 10F') to a target (61).

15. The photodetector (10A, 10A', 10B, 10C, 10D, 10E, 10F, 10F') according to claim 14 included in an optical detection system (R), the optical detection system (R) being included in a laser imaging detection and ranging (LIDAR) device (50), the LIDAR device (50) comprising:
a light source (54) configured to irradiate an object with light, wherein
the optical detection system (R) is configured to detect light reflected by the object.
